# FASCICULE DE BREVET EUROPEEN

(11) **EP 4 280 000 B1**
(45) Date de publication et mention de la délivrance du brevet: **18.02.2026**
(21) Numéro de dépôt: 22174146.5
(22) Date de dépôt: 18.05.2022
(51) Int. Cl.: G04C 10/02, G04G 17/02

(54) **COMPOSANT D'HABILLAGE D'UNE MONTRE COMPRENANT UNE CELLULE PHOTOVOLTAÏQUE ET MONTRE COMPORTANT LEDIT COMPOSANT D'HABILLAGE**
VERKLEIDUNGSKOMPONENTE EINER UHR MIT EINER FOTOVOLTAIKZELLE UND UHR MIT DIESER VERKLEIDUNGSKOMPONENTE
TRIM COMPONENT FOR A WATCH COMPRISING A PHOTOVOLTAIC CELL AND WATCH COMPRISING SAID TRIM COMPONENT

(43) Date de publication de la demande: 22.11.2023
(73) Titulaire: The Swatch Group Research and Development Ltd, 2074 Marin (CH)
(72) Inventeur: HAKOBYAN, Sargis, 2017 Boudry (CH); JORNOD, Alain, 2000 Neuchâtel (CH); GUEISSAZ, François, 2036 Cormondrèche (CH)
(74) Mandataire: ICB SA

(56) Documents cités:
- WO-A1-97/27520
- DE-T2- 69 735 159
- JP-A- 2006 275 525
- US-A1- 2020 028 004

## Description

### Domaine technique de l'invention

L'invention relève du domaine des composants d'habillage de pièces d'horlogerie.

Plus particulièrement, l'invention concerne un composant d'habillage d'une montre comprenant une cellule photovoltaïque et une montre comportant ledit composant d'habillage. Des exemples de l'art antérieur relatifs à un composant d'habillage d'une montre comprenant une cellule photovoltaïque sont divulgués par le brevet DE 697 35 159 T2.

### Arrière-plan technologique

Au-delà d'une certaine surface, typiquement quelques dixièmes de centimètres carrés ou quelques centimètres carrés, les cellules photovoltaïques réalisées en matériau semi-conducteur comportent une électrode supérieure sous la forme d'un réseau de lignes métalliques conformées en quadrillage et une électrode inférieure agencées de part et d'autre d'une cellule solaire élémentaire.

L'électrode supérieure est agencée sur la face de la cellule photovoltaïque soumise à un rayonnement lumineux incident et a pour fonction de collecter les porteurs de charges générés par la cellule solaire élémentaire. La disposition de l'électrode supérieure à la surface de la cellule solaire résulte d'un compromis entre le taux de masquage de la face de la cellule solaire sur laquelle elle est déposée et l'absorption optique de la cellule solaire élémentaire.

Dans le cas d'une cellule photovoltaïque destinée à être agencée sur un cadran d'une montre, pour des raisons d'ordre esthétique, l'électrode supérieure est généralement disposée de sorte à se soustraire à la vue d'un utilisateur, afin que seule la cellule solaire élémentaire soit visible. Cela réduit considérablement le rendement de la cellule photovoltaïque, particulièrement à haute illumination en raison de la résistance électrique induite par l'électrode masquée, moins optimale qu'une électrode visible.

Afin de pallier cet inconvénient, des montres ont été conçues de sorte à présenter un cadran ajouré par un ensemble de trous invisibles à l'œil nu ou bien un cadran translucide, superposé à une cellule photovoltaïque, ce type d'approche permettant de cacher l'électrode agencée sur la cellule.

La cellule photovoltaïque n'est ainsi pas ou peu visible pour un utilisateur, mais ces solutions ne sont pas satisfaisantes dans la mesure où le cadran bloque une partie du rayonnement lumineux susceptible d'atteindre ladite cellule photovoltaïque, ce qui impacte négativement son rendement.

### Résumé de l'invention

L'invention résout les inconvénients précités et concerne, à cet effet, un composant d'habillage d'une montre comprenant une cellule photovoltaïque comportant une cellule solaire élémentaire interposée entre deux électrodes, dont l'une dite « électrode supérieure » est agencée sur une face de la cellule solaire élémentaire destinée à être soumise à un rayonnement lumineux incident et destinée à être visible pour un utilisateur.

L'électrode supérieure est formée par des segments reliés les uns aux autres et agencés suivant un motif prédéterminé, par exemple, conforme à une représentation graphique d'une constellation, la cellule photovoltaïque étant destinée à être électriquement connectée à un mouvement horloger électronique.

L'électrode supérieure comporte une portion périphérique agencée en périphérie de la face de la cellule solaire élémentaire destinée à recevoir un rayonnement lumineux incident. La portion périphérique définit une aire au sein de laquelle s'étendent les segments, lesdits segments étant reliés à la portion périphérique.

Avantageusement, l'électrode supérieure peut ainsi générer un décor tout en permettant à la cellule photovoltaïque de présenter un rendement amélioré sans péjorer l'esthétique de la pièce.

Dans des modes particuliers de réalisation, l'invention peut comporter en outre l'une ou plusieurs des caractéristiques suivantes.

Cette caractéristique participe à augmenter le rendement de la cellule photovoltaïque en améliorant la récolte des porteurs de charges et abaissant la résistance de l'électrode supérieure.

Suivant l'invention revendiquée, le composant d'habillage comprend un cadran doté d'un guichet au regard duquel la cellule photovoltaïque est configurée pour être agencée. Le composant d'habillage comporte en outre un afficheur mobile interposé entre le cadran et la cellule photovoltaïque et étant destiné à être entraîné en déplacement par le mouvement horloger de sorte qu'au moins une partie de sa course soit visible à travers le guichet.

Grâce aux caractéristiques de l'invention, la cellule photovoltaïque peut s'intégrer par exemple dans un module de phase de lune, et en particulier, la cellule solaire élémentaire peut constituer le fond de la phase de lune.

Selon un autre aspect, la présente invention concerne une montre comportant un mouvement horloger électronique et un composant d'habillage tel que décrit précédemment, dans lequel la structure porteuse est formée par un pont ou une platine du mouvement horloger.

Dans des modes particuliers de réalisation, la montre comporte le composant d'habillage, et la cellule photovoltaïque matérialise un fond de phase de lune et représente une voute céleste, l'afficheur mobile comportant au moins une représentation d'une lune.

La présente invention permet, grâce aux segments de l'électrode supérieure, de générer une représentation graphique d'une constellation afin de générer un décor tout en augmentant le rendement de la cellule photovoltaïque.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente schématiquement une vue de face d'une cellule photovoltaïque d'un composant d'habillage selon un exemple préféré de réalisation de l'invention ;
- la figure 2 représente schématiquement une vue en perspective d'une partie d'un composant d'habillage selon un exemple préféré de réalisation de l'invention ;
- la figure 3 représente une vue en coupe transversale d'un composant d'habillage installé sur un mouvement horloger d'une montre.

### Description détaillée de l'invention

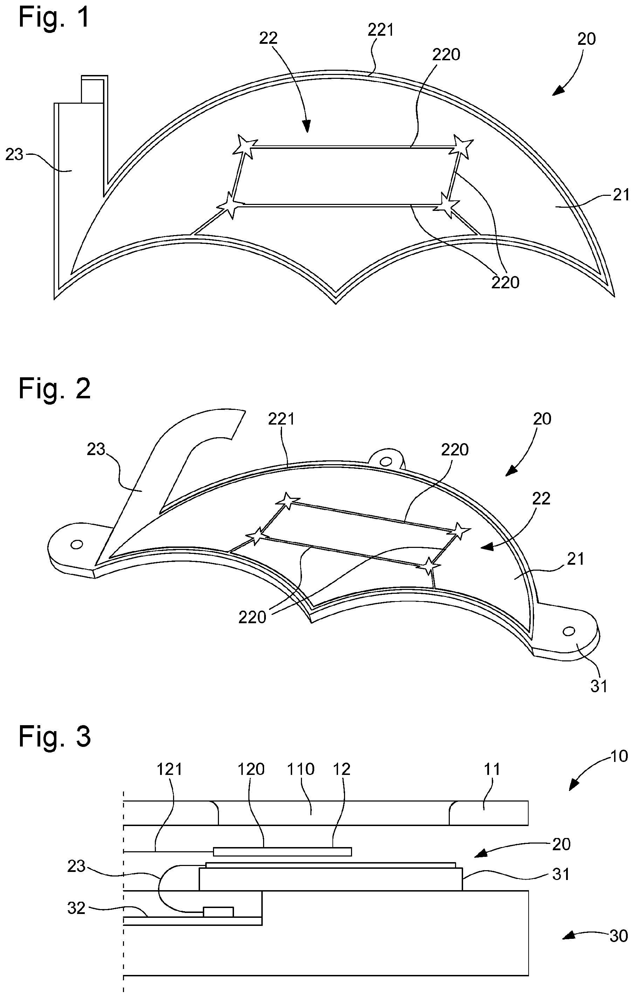

La figure 1 montre un composant d'habillage 10 d'une montre selon un exemple de réalisation de l'invention. Le composant d'habillage 10 comprend une cellule photovoltaïque 20 comportant une cellule solaire élémentaire 21 interposée entre deux électrodes. La cellule photovoltaïque 20 est destinée à être électriquement connectée à un mouvement horloger 30 électronique de la montre.

Le mouvement horloger 30 de la montre comporte un organe de stockage d'électricité, tel qu'une batterie, destiné à alimenter en énergie, par le biais d'un circuit électronique 32, au moins un moteur électrique permettant d'entraîner en rotation un afficheur des heures et un afficheur des minutes par l'intermédiaire de rouages.

Une électrode dite « électrode supérieure » 22 est destinée à être visible par un utilisateur et est agencée sur une face de la cellule solaire élémentaire 21 destinée à être soumise à un rayonnement lumineux incident. Une électrode inférieure, par exemple sous la forme d'une couche mince métallique, (non représentée sur les figures) est agencée de façon opposée à l'électrode supérieure 22 sur la cellule solaire élémentaire 21.

L'électrode supérieure 22 est formée par des segments 220 reliés les uns à la suite des autres, réalisés dans un matériau conducteur électrique, par exemple un matériau métallique, tel que de l'or ou de l'argent. Ces segments 220 sont agencés suivant un motif prédéterminé d'une représentation graphique d'au moins une constellation, tel que visible sur les figures 1 et 2.

Ainsi, le composant d'habillage 10 comporte des représentations d'étoiles, une représentation d'étoile étant agencée à la jonction entre deux segments 220. Les représentations d'étoiles peuvent être réalisées dans le même matériau que celui dans lequel sont réalisés les segments 220.

Plus particulièrement, comme visible sur les figures 1 et 2, l'électrode supérieure 22 comporte une portion périphérique 221 connectée aux segments 220 et agencée en périphérie de la face de la cellule solaire élémentaire 21 destinée à recevoir un rayonnement lumineux incident. Autrement dit, cette portion périphérique 221 forme une aire au sein de laquelle s'étendent les segments 220, depuis ladite portion périphérique 221.

La portion périphérique 221 est reliée à une languette de connexion 23 destinée à être connectée au mouvement horloger 30 de sorte à transmettre l'électricité collectée par la cellule solaire élémentaire 21 à l'organe de stockage d'électricité. Plus précisément, la languette de connexion 23 est destinée à être connectée au circuit électronique 32 par exemple par un film thermoadhésif conducteur anisotrope, par le biais d'un connecteur sans force d'insertion ou par le biais d'une partie de circuit imprimé flexible fixée sur le circuit électronique 32 par exemple par un adhésif conducteur anisotrope.

Dans un exemple préféré de réalisation de l'invention, le composant d'habillage 10 comporte un cadran 11, comme le montre la figure 3, doté d'un guichet 110 au regard duquel la cellule photovoltaïque 20 est configurée pour être agencée. Ainsi, un utilisateur peut voir la cellule photovoltaïque 20 à travers le guichet, et ladite cellule photovoltaïque 20 peut être soumise à un rayonnement lumineux.

Dans l'exemple de réalisation représenté sur les figures 2 et 3, la cellule photovoltaïque 20 est destinée à être rigidement fixée, c'est-à-dire fixée sans degré de liberté, par exemple par collage, sur une structure porteuse 31. Une telle structure porteuse 31 peut être formée par exemple par un pont, tel que représenté sur les figures 2 et 3, ou par une platine du mouvement horloger 30.

Le composant d'habillage 10 comporte en outre préférentiellement un afficheur mobile 12 interposé entre le cadran 11 et la cellule photovoltaïque 20. L'afficheur mobile 12 est destiné à être entraîné en déplacement par le mouvement horloger 30 de sorte qu'au moins une partie de sa course soit visible à travers le guichet 110.

En particulier, l'afficheur mobile 12 comporte au moins une représentation d'une lune et est destiné à être déplacé en regard du guichet 110 de sorte que sa course corresponde avec une lunaison. Dans l'exemple de réalisation représenté sur la figure 3, l'afficheur mobile 12 comporte au moins un disque excentrique 120 représentant une lune, fixé à l'extrémité d'une tige 121 destinée à être entraînée en rotation par le mouvement horloger 30 de sorte que ledit disque excentrique 120 se déplace selon une trajectoire circulaire. Alternativement, l'afficheur mobile 12 peut comporter un disque réalisé dans un matériau transparent, sur lequel est représenté au moins une lune de façon excentrée. Le disque est agencé pour être entraîné en rotation par le mouvement autour d'un axe passant par son centre, de sorte que la représentation de la lune se déplace selon une trajectoire circulaire.

La lune peut être représentée par impression, tel que tampographie, par gravure ou par tout autre moyen approprié connu par l'homme du métier.

La cellule photovoltaïque 20 matérialise un fond de phase de lune et représente une voute céleste dont le fond est de la couleur de la cellule solaire élémentaire 21, et comprenant au moins une constellation représentée par l'électrode supérieure 22.

La cellule solaire élémentaire 21 comprend, dans l'exemple préféré de réalisation de l'invention, au moins une couche réalisée dans un matériau semi-conducteur, par exemple en arséniure de gallium ou en silicium, sur laquelle est superposée une couche antireflet.

Avantageusement, l'électrode supérieure 22 de la cellule photovoltaïque 20 peut être réalisée par photolithographie sur un substrat constitué par la cellule solaire élémentaire 21.

Des tests ont démontré qu'une cellule photovoltaïque 20 selon l'invention présentant une cellule solaire élémentaire 21 de 0,3 cm² est apte à fournir suffisamment d'électricité au mouvement horloger 30 pour assurer son fonctionnement de façon pérenne, sous une illumination de 1 W/m² et dans une configuration de l'électrode supérieure 22 telle que représentée schématiquement sur les figures 1 et 2.

Dans un autre exemple de réalisation qui n'est pas couvert par le libellé des revendications, la cellule photovoltaïque 20 peut être agencée sur le cadran 11, de sorte que l'électrode supérieure 22 représente une constellation sur la face du cadran 11 destinée à être visible.

## Revendications

1. Composant d'habillage (10) d'une montre comprenant une cellule photovoltaïque (20) comportant une cellule solaire élémentaire (21) interposée entre deux électrodes, dont l'une dite « électrode supérieure » (22) est agencée sur une face de la cellule solaire élémentaire (21) destinée à être soumise à un rayonnement lumineux incident, ladite électrode supérieure (22) étant formée par des segments (220) reliés les uns aux autres et agencés suivant un motif prédéterminé, ladite électrode supérieure (22) comportant une portion périphérique (221) agencée en périphérie de ladite face de la cellule solaire élémentaire (21), les segments (220) s'étendant au sein d'une aire définie par ladite portion périphérique (221) et étant reliés à cette dernière, la cellule photovoltaïque (20) étant destinée à être électriquement connectée à un mouvement horloger (30) électronique, le composant d'habillage étant **caractérisé en ce qu'**il comporte un cadran (11) doté d'un guichet (110) au regard duquel la cellule photovoltaïque (20) est configurée pour être agencée, le composant d'habillage (10) comportant en outre un afficheur mobile (12) interposé entre le cadran (11) et la cellule photovoltaïque (20) et étant destiné à être entraîné en déplacement par le mouvement horloger (30) de sorte qu'au moins une partie de sa course soit visible à travers le guichet (110).

2. Composant d'habillage (10) selon la revendication 1, dans lequel le motif prédéterminé est conforme à une représentation graphique d'une constellation

3. Montre comportant un mouvement horloger (30) électronique et un composant d'habillage (10) selon l'une des revendications 1 ou 2, dans lequel la structure porteuse (31) est formée par un pont ou une platine du mouvement horloger (30).

4. Montre selon la revendication 3 comportant un composant d'habillage (10) selon la revendication 1 ou 2, dans laquelle la cellule photovoltaïque (20) matérialise un fond de phase de lune et représente une voute céleste, l'afficheur mobile (12) comportant au moins une représentation d'une lune.

## Patentansprüche

1. Gehäusebauteil (10) einer Uhr, umfassend eine Photovoltaikzelle (20) mit einer zwischen zwei Elektroden angeordneten elementaren Solarzelle (21), wobei eine der Elektroden, nachfolgend als "obere Elektrode" (22) bezeichnet, auf einer Seite der elementaren Solarzelle (21) angeordnet ist, die dazu bestimmt ist, mit einfallender Lichtstrahlung beaufschlagt zu werden, wobei die obere Elektrode (22) aus miteinander verbundenen Segmenten (220) gebildet ist, die gemäß einem vorbestimmten Muster angeordnet sind, wobei die obere Elektrode (22) einen peripheren Abschnitt (221) aufweist, der am Rand der genannten Seite der elementaren Solarzelle (21) angeordnet ist, wobei sich die Segmente (220) innerhalb eines von dem peripheren Abschnitt (221) definierten Bereichs erstrecken und mit diesem verbunden sind, wobei die Photovoltaikzelle (20) dazu bestimmt ist, elektrisch mit einem elektronischen Uhrwerk (30) verbunden zu werden, **dadurch gekennzeichnet, dass** das Gehäusebauteil ein Zifferblatt (11) mit einem Fenster (110) umfasst, in dessen Bereich die Photovoltaikzelle (20) zur Anordnung konfiguriert ist, wobei das Gehäusebauteil (10) ferner ein zwischen dem Zifferblatt (11) und der Photovoltaikzelle (20) angeordnetes bewegliches Anzeigeelement (12) umfasst, das dazu bestimmt ist, durch das Uhrwerk (30) in Bewegung versetzt zu werden, so dass mindestens ein Teil seines Weges durch das Fenster (110) sichtbar ist.

2. Gehäusebauteil (10) nach Anspruch 1, wobei das vorbestimmte Muster einer graphischen Darstellung eines Sternbilds entspricht.

3. Uhr, umfassend ein elektronisches Uhrwerk (30) und ein Gehäusebauteil (10) nach einem der Ansprüche 1 oder 2, wobei die Trägerstruktur (31) durch eine Brücke oder eine Platine des Uhrwerks (30) gebildet ist.

4. Uhr nach Anspruch 3, umfassend ein Gehäusebauteil (10) nach Anspruch 1 oder 2, wobei die Photovoltaikzelle (20) den Hintergrund einer Mondphasenanzeige bildet und ein Himmelsgewölbe darstellt, wobei das bewegliche Anzeigeelement (12) mindestens eine Darstellung eines Mondes aufweist.

## Claims

1. An external part component (10) of a watch comprising a photovoltaic cell (20) including an elementary solar cell (21) interposed between two electrodes, one of which so-called "upper electrode" (22) is arranged over a face of the elementary solar cell (21) intended to be subjected to an incident light radiation, said upper electrode (22) being formed by segments (220) connected together and arranged according to a predetermined pattern, said upper electrode (22) including a peripheral portion (221) arranged at the periphery of said face of the elementary solar cell (21), the segments (220) extending within an area defined by said peripheral portion (221) and being connected to the latter, the photovoltaic cell (20) being intended to be electrically connected to an electronic horological movement (30), the external part component (10) being **characterised in that** it comprises a dial (11) provided with an aperture (110) opposite which the photovoltaic cell (20) is configured to be arranged, the external part component (10) further including a movable display (12) interposed between the dial (11) and the photovoltaic cell (20) and being intended to be driven in motion by the horological movement (30) so that at least one portion of its travel is visible through the aperture (110).

2. The external part component (10) according to claim 1, wherein the predetermined pattern matches with a graphical representation of a constellation

3. A watch including an electronic horological movement (30) and an external part component (10) according to one of claims 1 or 2, wherein the photovoltaic cell (20) is fastened without any degree of freedom on a carrier structure (31) formed by a bridge or a plate of the horological movement (30).

4. The watch according to claim 3, including an external part component (10) according to claim 1 or 2, wherein the photovoltaic cell (20) materialises a lunar phase background and represents a sky vault, the movable display (12) including at least one representation of a moon.
